# EUROPÄISCHE PATENTANMELDUNG

(11) **EP 1 248 397 A2**
(43) Veröffentlichungstag der Anmeldung: **09.10.2002**
(21) Anmeldenummer: 02006280.8
(22) Anmeldetag: 20.03.2002
(51) Int. Cl.: H04H 1/00, H03J 1/00

(54) **Verfahren zum Abstimmen eines RDS-Rundfunkempfängers**

(30) Priorität: 04.04.2001 DE 10116564
(71) Anmelder: SIEMENS AKTIENGESELLSCHAFT, 80333 München (DE)
(72) Erfinder: Geurts, Joris Hubertt Joseph, 5653 Eindhoven (NL); de Jong, Frits, 5672 VD Nuenen (NL)

(57) **Zusammenfassung**

Es wird ein Verfahren zum Abstimmen eines RDS-Rundfunkempfängers auf ein Rundfunkprogramm eines am Rundfunkempfänger ausgewählten Programmtyps vorgeschlagen, wobei zum Zeitpunkt der Auswahl des RDS-Programmtyps kein entsprechendes Rundfunkprogramm mit dem Rundfunkempfänger empfangbar ist. Erfindungsgemäß ist insbesondere vorgesehen, dass ein Sendersuchlauf kontinuierlich oder quasi-kontinuierlich durchgeführt wird, um Rundfunkprogramme des ausgewählten Programmtyps zu detektieren. Wird ein solches Programm detektiert, erfolgt ein Hinweis an den Benutzer, worauf dieser ein Umschalten veranlaßt.

## Beschreibung

Die Erfindung betrifft ein Verfahren zum Abstimmen eines RDS - Rundfunkempfängers auf ein Rundfunkprogramm eines am Rundfunkempfänger ausgewählten RDS-Programmtyps.

Durch die Einführung des Radio-Data-Systems (RDS) konnte die Funktionalität von Rundfunkempfängern und hierbei insbesondere von Autoradios deutlich erhöht werden. Bei RDS handelt es sich um ein standardisiertes Verfahren zur Übertragung von Daten von den Rundfunkanstalten zu einem Rundfunkempfänger. Zu den übertragenen Daten gehören beispielsweise Angaben über alternative Frequenzen (AF), den Namen der Rundfunkanstalt (PS), die Kennzeichnung einer Verkehrsdurchsage (TA) und den Programmtyp (PTY). Der RDS-Standard ist in der internationalen Norm IEC 62106 festgeschrieben.

Innerhalb des RDS-Systems wird durch den Programmtypcode PTY eine Charakterisierung des Rundfunkprogramms von den Rundfunkanstalten zu dem Rundfunkempfänger übertragen. Hierzu sind in Annex F der oben genannten RDS-Norm insgesamt 31 Programmtypen vordefiniert. Die Kennzeichnung eines Rundfunkprogramms wird hierbei von dem Programmanbieter, also der Rundfunkanstalt, vorgenommen. Aus der DE 42 33 282 A1 ist ein Rundempfänger bekannt, bei dem der mit den RDS-Daten übertragene PTY-Code zum Abstimmen des Rundfunkempfängers genutzt wird.

Es ist bekannt, nach Auswahl eines PTY-Programmtyps durch den Benutzer einen Suchlauf zu starten, um ein Rundfunkprogramm aufzufinden, das zur Zeit gerade den aktuellen Programmtyp sendet. Weiterhin ist es bekannt, einen Suchlauf zu starten, um alle zur Zeit empfangbaren Programmtypen festzustellen. Der Benutzer kann dann aus den zur Zeit verfügbaren Programmtypen einen gewünschten auswählen. Weiterhin ist es bekannt, einen zeitweisen Wechsel zu einem anderen Programm durchzuführen, wenn dieses andere Programm einen bestimmten Programmtyp anbietet. Beispiele dafür sind insbesondere das kurzzeitige Umschalten auf Nachrichten oder Wettervorhersagen. Dieses automatische, zeitlich begrenzte Umschalten erfolgt dabei jedoch nur zwischen Sendern, die zu einer Sendergruppe gehören, aufgrund der mit den RDS-Daten übertragenen "Enhanced Other Network" (EON) Informationen gemäß o. g. Norm.

Aufgabe der Erfindung ist es, ein Verfahren zum Abstimmen eines RDS- Rundfunkempfängers anzugeben, bei dem ein Umschalten auf ein Rundfunkprogramm eines gewünschten Programmtyps auch dann erfolgt, wenn die Rundfunksender nicht zu einer Sendergruppe gehören.

Die Aufgabe wird gelöst durch ein Verfahren zum Abstimmen eines RDS-Rundfunkempfängers auf ein Rundfunkprogramm eines am Rundfunkempfänger ausgewählten RDS-Programmtyps, wobei zum Zeitpunkt der Auswahl des RDS-Programmetyps kein entsprechendes Rundfunkprogramm mit dem Rundfunkempfänger empfangbar ist, mit den Verfahrensschritten:
- Empfang eines Rundfunkprogramms für eine Audiowiedergabe auf einer ersten Empfangsfrequenz,
- Durchführen eines, vorzugsweise kontinuierlichen oder quasikontinuierlichen, Sendersuchlaufs,
- Empfangen und Auswerten der auf weiteren, sequenziell eingestellten Empfangsfrequenzen empfangenen RDS-Daten hinsichtlich eines Programmtypcodes,
- Vergleichen eines aus den RDS-Daten auf einer der weiteren Empfangsfrequenzen erhaltenen Programmtypcodes mit dem zu dem am Rundfunkempfänger ausgewählten Programmtyp gehörenden Programmtypcode, um Rundfunkempfänger zu identifizieren, die ein Rundfunkprogramm mit dem ausgewählten Programmtyp ausstrahlen,
- Ausgabe eines akustischen und/oder optischen Hinweises und Starten eines Zeitgebers für eine vorgegebene Zeitdauer bei Identifizierung des ausgewählten Programmtyps,
- Überwachen eines Bedienelements des Rundfunkempfängers innerhalb der vorgegebenen Zeitdauer auf Betätigung,
- Umschalten der Audiowiedergabe auf die weitere Empfangsfrequenz, auf der das Rundfunkprogramm mit dem ausgewählten Programmtyp ausgestrahlt wird, wenn das Bedienelement innerhalb der vorgegebenen Zeitdauer betätigt wird.

Ausgangszustand des erfindungsgemäßen Verfahrens ist der Wunsch eines Benutzers, einen Programmtyp zu hören, zu dem zur Zeit mit den empfangbaren Sendern kein Angebot besteht. Der Rundfunkempfänger bietet dennoch die Möglichkeit, diesen Programmtyp auszuwählen. Dies geschieht auch durch den Benutzer, der für die Audiowiedergabe allerdings ein Rundfunkprogramm auf einer ersten Empfangsfrequenz auswählt, das nicht dem gewünschten Programmtyp entspricht. Gemäß dem erfindungsgemäßen Verfahren führt nun der Rundfunkempfänger einen Sendersuchlauf durch, während der Benutzer das Rundfunkprogramm auf der ersten Empfangsfrequenz hört. Dieser Sendersuchlauf wird vorzugsweise kontinuierlich oder quasi-kontinuierlich durchgeführt. Ein quasi-kontinuierlicher Sendersuchlauf kann bei einem Eintunerempfänger beispielsweise dadurch durchgeführt werden, dass in kurzen Zeitfenstern der Rundfunkempfänger jeweils auf weitere Empfangsfrequenzen eingestellt wird. Die Umschaltung auf eine weitere Empfangsfrequenz erfolgt dabei für einen Zeitraum von 100 ms bis einige 100 ms. Diese kurzen Unterbrechungen des Rundfunkempfangs sind für den Benutzer jedoch unter Umständen bemerkbar, so dass für das erfindungsgemäße Verfahren insbesondere ein Zwei-Tunerempfänger bevorzugt wird, bei dem das Rundfunkprogramm für die Audiowiedergabe über einen ersten Tuner bereitgestellt und der kontinuierliche oder quasi-kontinuierliche Sendersuchlauf über einen zweiten Tuner durchgeführt wird.

Die weiteren Frequenzen werden sequentiell eingestellt und die auf der jeweiligen weiteren Empfangsfrequenz empfangenen RDS-Daten werden hinsichtlich eines Programmtypcodes ausgewertet. Der auf der weiteren Frequenz empfangene Programmtypcode wird nun mit dem Programmtypcode verglichen, der zu dem am Rundfunkempfänger ausgewählten Programmtyp gehört. Durch diesen Vergleich werden Rundfunksender identifiziert, die ein Rundfunkprogramm mit dem ausgewählten Programmtyp ausstrahlen. Wird durch diesen Vergleich ein Programm aufgefunden, das dem vom Benutzer ausgewählten Programmtyp entspricht, so wird nachfolgend ein akustischer und/oder optischer Hinweis an den Benutzer ausgegeben. Zudem wird ein Zeitgeber für eine vorgegebene Zeitdauer von beispielsweise 10 Sekunden gestartet und innerhalb der vorgegebenen Zeitdauer wird überwacht, ob ein zugeordnetes Bedienelement des Rundfunkempfängers betätigt wird. Über dieses Bedienelement kann der Benutzer dem Rundfunkempfänger mitteilen, dass er eine Umschaltung auf den jetzt gefundenen Rundfunksender mit dem ausgewählten Programmtyp wünscht. Wird das Bedienelement innerhalb der vorgegebenen Zeitdauer betätigt, so schaltet der Rundfunkempfänger die Audiowiedergabe auf die weitere Empfangsfrequenz um, auf der das Rundfunkprogramm mit dem ausgewählten Programmtyp ausgestrahlt wird.

Mit dem erfindungsgemäßen Verfahren kann die Umschaltung somit auf jeden beliebigen Rundfunksender erfolgen, der den ausgewählten Programmtyp anbietet. Eine Beschränkung auf Rundfunksender, die zu einer Sendergruppe gehören, ist nicht erforderlich. Mit anderen Worten ist es nicht erforderlich, die mit den RDS-Daten übertragenen EON-Informationen für diesen Senderwechsel auszuwerten.

In einer besonderen Ausführungsform ist vorgesehen, dass mehrere RDS-Programmtypen am Rundfunkempfänger ausgewählt sind und der aus den RDS-Daten auf einer der weiteren Empfangsfrequenzen erhaltene Programmtypcode mit allen zu den am Rundfunkempfänger ausgewählten Programmtypen gehörenden Programmtypcodes verglichen wird. In der parallelen Patentanmeldung "RDS-Rundfunkempfänger mit PTY-Auswahl" der Patentanmelderin ist ein Rundfunkempfänger und ein Verfahren beschrieben, mit dem die Auswahl mehrerer Programmtypen und insbesondere auch die Zusammenfassung mehrerer Programmtypen zu einer Gruppe möglich ist. Der Benutzer kann hierbei beispielsweise eine Gruppe "Klassik" festlegen und später wieder auswählen, die die vordefinierten Programmtypen "light classics" und "serious classics" enthält. In diesem Fall wird mit dem erfindungsgemäßen Verfahren der auf weiteren Empfangsfrequenzen empfangene Programmtypcode mit allen zu den ausgewählten Programmtypen (hier: "light classics" und "serious classics") gehörenden Programmtypcodes verglichen. Durch diese Ausgestaltung kann der Benutzer die Auswahl seinen Wünschen individueller anpassen.

In einer besonderen Ausführungsform ist vorgesehen, dass der Sendersuchlauf in periodischen Zeitfenstern durchgeführt wird. Dies kann beispielsweise - wie oben bereits beschrieben - in kurzen Zeitfenstern bei einem Eintunerempfänger erfolgen. Bei einem Zweitunerempfänger kann dieser Sendersuchlauf dann jedoch auch mit dem zweiten Tuner im Hintergrund erfolgen, wobei der zweite Tuner verschiedene Aufgaben innerhalb verschiedener Zeitfenster übernimmt, wie beispielsweise den Sendersuchlauf und den Empfang von RDS-TMC-Verkehrmeldungen. Vorzugsweise werden die periodischen Zeitfenster hierbei gemäß dem standardisierten RDS-TMC "enhanced mode" der europäischen Vornorm ENV 12313-1 festgelegt.

Während bei bekannten Rundfunkempfängern eine zeitlich begrenzte Umschaltung auf eine weitere Empfangsfrequenz aufgrund der RDS-EON-Information erfolgen kann, ist vorgesehen, dass mit dem erfindungsgemäßen Verfahren das Umschalten auf die weitere Empfangsfrequenz dauerhaft erfolgt. Dies bedeutet, dass die weitere Empfangsfrequenz solange beibehalten wird, bis vom Benutzer eine neue Sendereinstellung vorgenommen wird.

Die Erfindung wird nachfolgend anhand der Zeichnung und eines Ausführungsbeispiels näher erläutert. Es zeigen:
- Fig. 1:: ein Blockschaltbild eines Rundfunkempfängers
- Fig. 2:: ein Ablaufdiagramm zu dem erfindungsgemäßen Verfahren
- Fig. 3:: ein Diagramm zur Erläuterung des Umschaltvorgangs
- Fig. 4:: die optische Darstellung eines Hinweises.

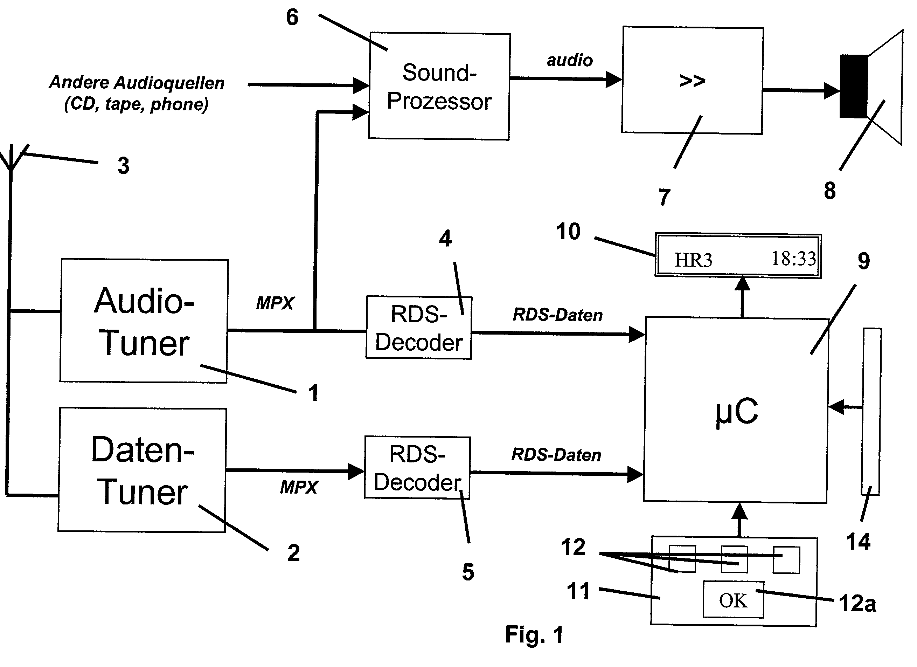

Fig. 1 zeigt ein vereinfachtes Blockschaltbild eines Rundfunkempfängers, insbesondere eines Autoradios, mit zwei Tunern, nämlich einem Audiotuner 1 und einem Datentuner 2. Die Bezeichnung der Tuner als Audiotuner bzw. Datentuner dient vorrangig zur einfacheren Unterscheidung. Eine strikte Trennung der Funktionen ist nicht erforderlich. Beispielsweise kann auch der Datentuner zumindest zeitweise Audiofunktionen übernehmen.

Die Tuner 1, 2 erhalten ihre Eingangssignale von einer Antenne 3. Alternativ können die Tuner 1, 2 auch von unterschiedlichen Antennen oder über mehrere Antennen in einem sogenannten "antenna diversity" - Verfahren versorgt werden.

Beide Tuner 1, 2 generieren jeweils ein Multiplexsignal MPX. Das MPX-Signal des Audiotuners 1 wird einem ersten RDS-Decoder 4 zugeführt. Das MPX-Signal des Datentuners 2 wird einem zweiten RDS-Decoder 5 zugeführt. Der hier als RDS-Decoder 4, 5 bezeichnete Baustein kann insbesondere ein bekannter Vorprozessor, beispielsweise des Typs SAA 6588, sein, der weitere Aufgaben übernimmt.

Das Ausgangssignal des Audiotuners 1 wird einem Soundprozessor 6 zugeführt, der auch Eingangssignale von weiteren Audioquellen, wie beispielsweise einem CD-Spieler, einem Kassettenabspielgerät oder einem Telefon erhält. Die von dem Soundprozessor 6 generierten Audiosignale werden einem Verstärker 7 zugeführt, der sie verstärkt an Lautsprecher 8 weiterleitet, über die die Audiosignale ausgegeben werden. Die Ausgangssignale der RDS-Decoder 4, 5 werden einer zentralen Steuereinheit 9 zugeführt, die die Aufbereitung der RDS-Informationen übernimmt. Die Steuereinheit 9 ist weiterhin mit einem Display 10 und einer Eingabeeinheit 11 verbunden. Die Eingabeeinheit 11 enthält mehrere Tasten 12, über die der Rundfunkempfänger bedient werden kann. Weiterhin kann auch eine Bedienung des Rundfunkempfängers über Spracheingabe vorgesehen sein. Insbesondere kann die gemäß dem erfindungsgemäßen Verfahren vorgesehene Betätigung eines Bedienelements auch durch Eingabe eines Sprachbefehls in ein Spracheingabemodul 14 erfolgen.

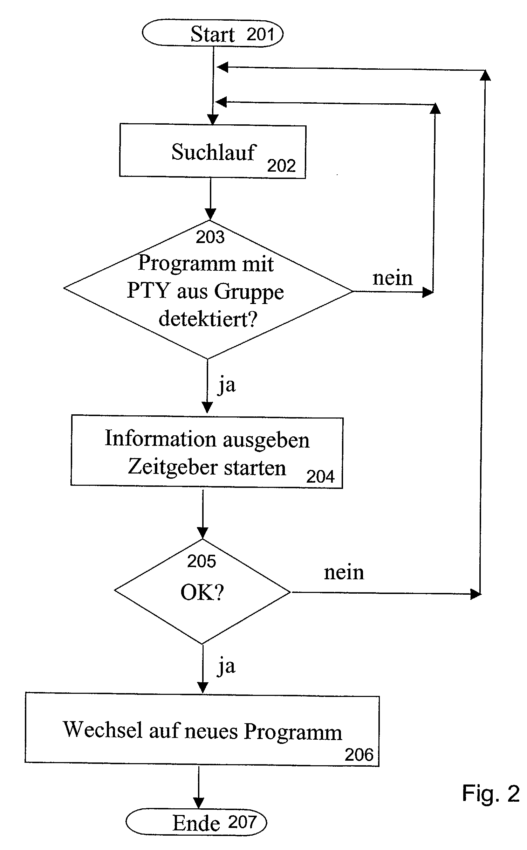

Fig. 2 zeigt einen Ablauf des erfindungsgemäßen Suchlaufs. In der Ausgangssituation hat der Benutzer einen bestimmten Rundfunksender für die Audiowiedergabe ausgewählt. Weiterhin hat der Benutzer einen Programmtyp, insbesondere auch eine Programmtypgruppe mit mehreren Programmtypen, ausgewählt, zu denen zur Zeit jedoch kein entsprechendes Rundfunkprogramm empfangbar ist. Nach dem Start des Verfahrens in Schritt 201 wird in Schritt 202 ein Suchlauf mit dem Datentuner 2 durchgeführt. In diesem Suchlauf wird am Datentuner 2 eine weitere Empfangsfrequenz eingestellt und es werden die auf dieser weiteren Empfangsfrequenz empfangenen RDS-Daten ausgewertet. Hierbei wird insbesondere in Schritt 203 geprüft, ob der detektierte PTY-Code mit einem Programmtyp übereinstimmt, der vom Benutzer am Rundfunkempfänger ausgewählt wurde. Ist dies nicht der Fall, so wird der Suchlauf in Schritt 202 mit der nächsten Empfangsfrequenz fortgeführt. Wird dagegen in Schritt 203 auf der eingestellten weiteren Empfangsfrequenz ein PTY-Code detektiert, der mit einem Programmtyp innerhalb der ausgewählten Programmtypgruppe übereinstimmt, so wird anschließend in Schritt 204 eine entsprechende Information akustisch und/oder optisch ausgegeben und ein Zeitgeber gestartet. In Schritt 205 wird überprüft, ob innerhalb der von dem Zeitgeber vorgegebenen Zeitdauer ein bestimmtes Bedienelement 12a betätigt wurde, wodurch dem Rundfunkempfänger signalisiert wird, dass der Benutzer ein Umschalten wünscht. Wird in Schritt 205 ein solches Betätigen des Bedienelements 12a nicht detektiert, so wird der Suchlauf mit der nächsten Empfangsfrequenz 202 durchgeführt. Alternativ kann das Programm an dieser Stelle auch abgebrochen werden. Wird dagegen im Schritt 205 festgestellt, dass das entsprechende Bedienelement 12a am Rundfunkempfänger betätigt wurde, so erfolgt in Schritt 206 ein Umschalten des Audiotuners auf die neue Empfangsfrequenz mit dem gewünschten Programmtyp. Das Verfahren endet dann in Schritt 207.

Alternativ kann das Verfahren nach Schritt 206 mit Schritt 202 fortgesetzt werden, d.h. es werden weiterhin Programme gesucht, die dem ausgesuchten Programmtyp oder einem der ausgesuchten Programmtypen einer Programmtypengruppe entsprechen. Wird dabei ein weiteres Rundfunkprogramm eines ausgewählten Programmtyps gefunden, so kann dieses dem Benutzer wie oben beschrieben angezeigt und zur Auswahl angeboten werden. Das Verfahren kann jedoch auch derart ausgebildet sein, dass nur kann eine erneute Anzeige erfolgt, wenn der Programmtyp des weiteren aufgefundenen Rundfunkprogramms vom Programmtyp des eingestellten Rundfunkprogramms für Audiowiedergabe abweicht. Letzteres kann insbesondere dann von Bedeutung sein, wenn eine Programmtypgruppe ausgewählt wurde.

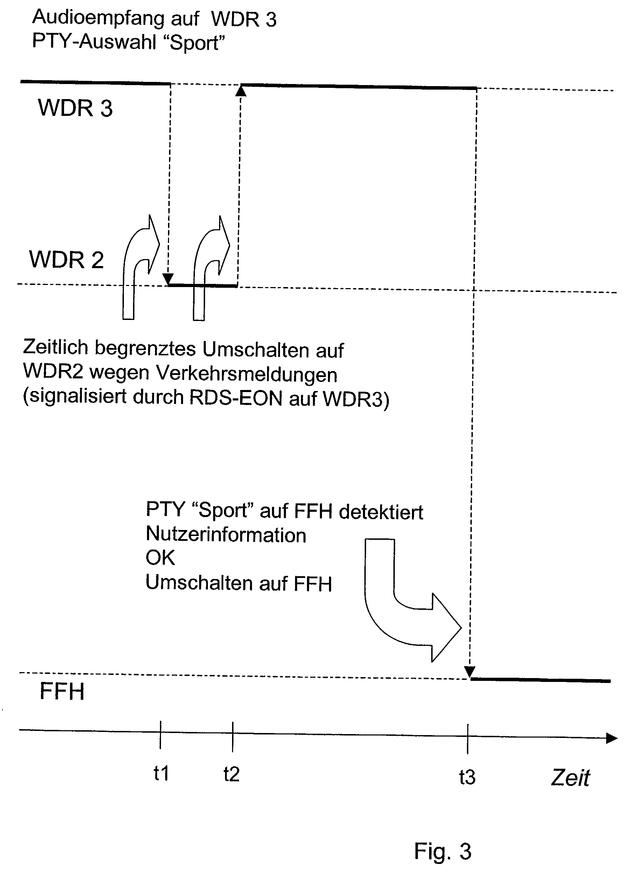

In Fig. 3 ist der zeitliche Ablauf der unterschiedlichen Abstimmung des Rundfunkempfängers auf eine Empfangsfrequenz für Audiowiedergabe dargestellt. Für den Audioempfang wurde zunächst ein Rundfunkprogramm des Rundfunksenders WDR3 gewählt. Zudem hat der Benutzer den Programmtyp "Sport" ausgewählt, zu dem zunächst jedoch kein entsprechendes Programmangebot vorliegt. Zum Zeitpunkt t1 erfolgt ein zeitlich begrenztes Umschalten auf den Sender WDR2 zum Empfang von Verkehrsmeldungen, wobei dieses zeitlich begrenzte Umschalten dem Rundfunkempfänger durch die empfangenen RDS-EON-Daten auf der Empfangsfrequenz des Senders WDR3 signalisiert wird. Nach Ende der Verkehrsdurchsagen auf WDR2 erfolgt zum Zeitpunkt t2 wieder ein Umschalten auf die Empfangsfrequenz für WDR3. Ein solches zeitlich begrenztes Umschalten der Empfangsfrequenz auf einen anderen Sender der gleichen Senderkette ist bekannt und nicht Gegenstand der Erfindung.

Im Hintergrund werden von dem Datentuner 2 ständig Rundfunkprogramme in einem Sendersuchlauf gesucht, die dem gewünschten Programmtyp "Sport" entsprechen. Zum Zeitpunkt t3 wird ein solcher Programmtyp auf einer Empfangsfrequenz des Rundfunksenders FFH detektiert. Anschließend wird das in Fig. 2 angegebene Verfahren durchgeführt, wobei insbesondere der Benutzer über das Vorliegen des von ihm ausgewählten Programmtyps informiert wird, die Betätigung einer Auswahltaste überwacht wird, und bei Betätigen der Auswahltaste ein Umschalten auf den Rundfunksender FFH erfolgt. Dieses erfindungsgemäße Umschalten erfolgt unabhängig von der Zugehörigkeit des Senders FFH zu einer bestimmten Sendergruppe und zudem dauerhaft.

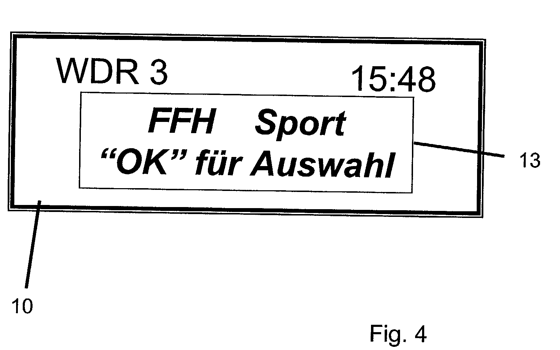

In Fig. 4 zeigt eine Bildschirmdarstellung, mit der der Benutzer darauf hingewiesen wird, dass nunmehr ein Rundfunkprogramm mit dem von ihm gewünschten Programmtyp verfügbar ist. Dazu wird auf dem Display 10 in einem Anzeigefeld 13 eine entsprechende Information ausgegeben. Zusätzlich kann ein akustischer Hinweis vorgesehen sein.

## Patentansprüche

1. Verfahren zum Abstimmen eines RDS-Rundfunkempfängers auf ein Rundfunkprogramm eines am Rundfunkempfänger ausgewählten RDS-Programmtyps, wobei zum Zeitpunkt der Auswahl des RDS-Programm typs kein entsprechendes Rundfunkprogramm mit dem Rundfunkempfänger empfangbar ist, mit den Verfahrensschritten:
- Empfang eines Rundfunkprogramms für eine Audiowiedergabe auf einer ersten Empfangsfrequenz,
- Durchführen eines, vorzugsweise kontinuierlichen oder quasikontinuierlichen, Sendersuchlaufs,
- Empfangen und Auswerten der auf weiteren, sequenziell eingestellten Empfangsfrequenzen empfangenen RDS-Daten hinsichtlich eines Programmtypcodes,
- Vergleichen eines aus den RDS-Daten auf einer der weiteren Empfangsfrequenzen erhaltenen Programmtypcodes mit dem zu dem am Rundfunkempfänger ausgewählten Programmtyp gehörenden Programmtypcode, um Rundfunksender zu identifizieren, die ein Rundfunkprogramm mit dem ausgewählten Programmtyp ausstrahlen,
- Ausgabe eines akustischen und / oder optischen Hinweises und Starten eines Zeitgebers für eine vorgegebene Zeitdauer bei Identifizierung des ausgewählten Programmtyps,
- Überwachen eines Bedienelements des Rundfunkempfängers innerhalb der vorgegebenen Zeitdauer auf Betätigung,
- Umschalten der Audiowiedergabe auf die weitere Empfangsfrequenz, auf der das Rundfunkprogramm mit dem ausgewählten Programmtyp ausgestrahlt wird, wenn das Bedienelement innerhalb der vorgegebenen Zeitdauer betätigt wird.

2. Verfahren nach Anspruch 1, **dadurch gekennzeichnet, dass** das Rundfunkprogramm für die Audiowiedergabe über einen ersten Tuner bereitgestellt wird und der kontinuierliche oder quasi-kontinuierliche Sendersuchlauf über einen zweiten Tuner durchgeführt wird.

3. Verfahren nach Anspruch 1 oder 2, **dadurch gekennzeichnet, dass** mehrere RDS-Programmtypen am Rundfunkempfänger ausgewählt sind und der aus den RDS-Daten auf einer der weiteren Empfangsfrequenzen erhaltene RDS-Programmtypcode mit allen zu dem am Rundfunkempfänger ausgewählten Programmtypen gehörenden Programmtypcodes verglichen wird.

4. Verfahren nach Anspruch 3, **dadurch gekennzeichnet, dass** die ausgewählten Programmtypen als Gruppe ausgewählt sind.

5. Verfahren nach einem der vorhergehenden Ansprüche, **dadurch gekennzeichnet, dass** der Sendersuchlauf in periodischen Zeitfenstern durchgeführt wird.

6. Verfahren nach Anspruch 5, **dadurch gekennzeichnet, dass** die periodischen Zeitfenster gemäß dem standardisierten RDS-TMC enhanced mode festgelegt werden.

7. Verfahren nach einem der vorhergehenden Ansprüche, **dadurch gekennzeichnet, dass** das Umschalten der Audiowiedergabe unabhängig von der Zugehörigkeit eines Rundfunksenders auf der weiteren Empfangsfrequenz zu einer Senderkette erfolgt.

8. Verfahren nach einem der vorhergehenden Ansprüche, **dadurch gekennzeichnet, dass** das Umschalten auf die weitere Empfangsfrequenz dauerhaft erfolgt.

9. Verfahren nach einem der vorhergehenden Ansprüche, **dadurch gekennzeichnet, dass** das Bedienelement ein Spracheingabesystem ist.

10. Verfahren nach einem der vorhergehenden Ansprüche, **dadurch gekennzeichnet, dass** auch nach Umschalten der Audiowiedergabe auf die weitere Empfangsfrequenz, auf der das Rundfunkprogramm mit dem ausgewählten Programmtyp ausgestrahlt wird, weiterhin ein Suchlauf nach Rundfunkprogrammen eines ausgewählten Programmtyps durchgeführt wird.

11. Verfahren nach Anspruch 10, **dadurch gekennzeichnet, dass** das Auffinden eines weiteren Rundfunkprogramms eines ausgewählten Programmtyps dem Benutzer angezeigt wird.

12. Verfahren nach Anspruch 11, **dadurch gekennzeichnet, dass** das Auffinden eines weiteren Rundfunkprogramms eines ausgewählten Programmtyps dem Benutzer nur dann angezeigt wird, wenn der Programmtypcode des weiteren aufgefundenen Rundfunkprogramms vom Programmtypcode des eingestellten Rundfunkprogramms für Audiowiedergabe abweicht.
